**Europäisches Patentamt**

**European Patent Office**

**Office européen des brevets**

(19)

(11) Veröffentlichungsnummer: **0 238 978**

**A1**

(12) # EUROPÄISCHE PATENTANMELDUNG

(21) Anmeldenummer: **87103852.7**

(22) Anmeldetag: **17.03.87**

(51) Int. Cl.⁴: **H03K 19/21** , G06F 7/50

(30) Priorität: **25.03.86 DE 3610058**

(43) Veröffentlichungstag der Anmeldung:
**30.09.87 Patentblatt 87/40**

(84) Benannte Vertragsstaaten:
**AT BE DE FR GB IT NL SE**

(71) Anmelder: **Siemens Aktiengesellschaft Berlin und München**
**Wittelsbacherplatz 2**
**D-8000 München 2(DE)**

(72) Erfinder: **Holzapfel, Heinz Peter**
**Blütenstrasse 14**
**D-8000 München 40(DE)**
Erfinder: **Horninger, Karlheinrich**
**Oskar-Maria-Graf-Strasse 13**
**D-8013 Grafing(DE)**

(54) **Modulo-2-Addierer zur Verknüpfung von drei Eingangssignalen.**

(57) Zur Erzeugung von Prüfbits für Datenworte wird die Modulo-2-Addition von Datenbits des Datenwortes durchgeführt. Die Schaltzeit zur Erzeugung von solchen Prüfbits und der Aufwand an dazu notwendigen Transistoren kann dann verringert werden, wenn dreiwertige Modulo-2-Addierer zur Verfügung stehen. Mit diesen werden je drei Eingangssignale verknüpft. Die dreiwertigen Modulo-3-Addierer bestehen aus vier Schaltungsteilen (SC1, SC2, SC3, SC4) und einer Auswerteschaltung (AW). Mit dem ersten Schaltungsteil (SC1) wird ein dem ersten Binärwert ("1") entsprechendes Zwischensignal erzeugt, wenn jeweils zwei der Eingangssignale (A,B,C) den anderen Binärwert ("0") annehmen. Der zweite Schaltungsteil (SC2) erzeugt ein dem anderen Binärwert entsprechendes Zwischensignal (ZS2), wenn jeweils zwei Eingangssignale den einen Binärwert einnehmen. Das am Augang des dritten Schaltungsteils (SC3) abgegebene Zwischenwert ist binär "0", wenn alle drei Eingangssignale den Binärwert "1" annehmen. Schließlich gibt der vierte Schaltungsteil (SC4) den Binärwert "1" ab, wenn alle Eingangssignale den Binärwert "0" haben. Durch die Auswerteschaltung (AW1) wird das erste oder zweite Zwischensignal als Verknüpfungsergebnis zum Ausgang durchgeschaltet, wenn das dritte Zwischensignal binär "1" und das vierte Zwischensignal binär "0" ist, sonst wird das dritte oder vierte Zwischensignal in invertierter Form zum Ausgang durchgeschaltet.

FIG 3

## Modulo-2-Addierer zur Verknüpfung von drei Eingangssignalen

Die Erfindung bezieht sich auf einen Modulo-2-Addierer zur Verknüpfung von drei Eingangssignalen.

Modulo-2-Addierer werden häufig bei der Datenkontrolle von Datenworten verwendet, bei denen Prüfbits an das Datenwort angehängt werden. Die Prüfbits werden durch binäre Addition der Datenbits erzeugt. Die Anzahl der an ein Datenwort angehängten Prüfbits hängt davon ab, ob Fehler nur erkannt oder auch korrigiert werden sollen.

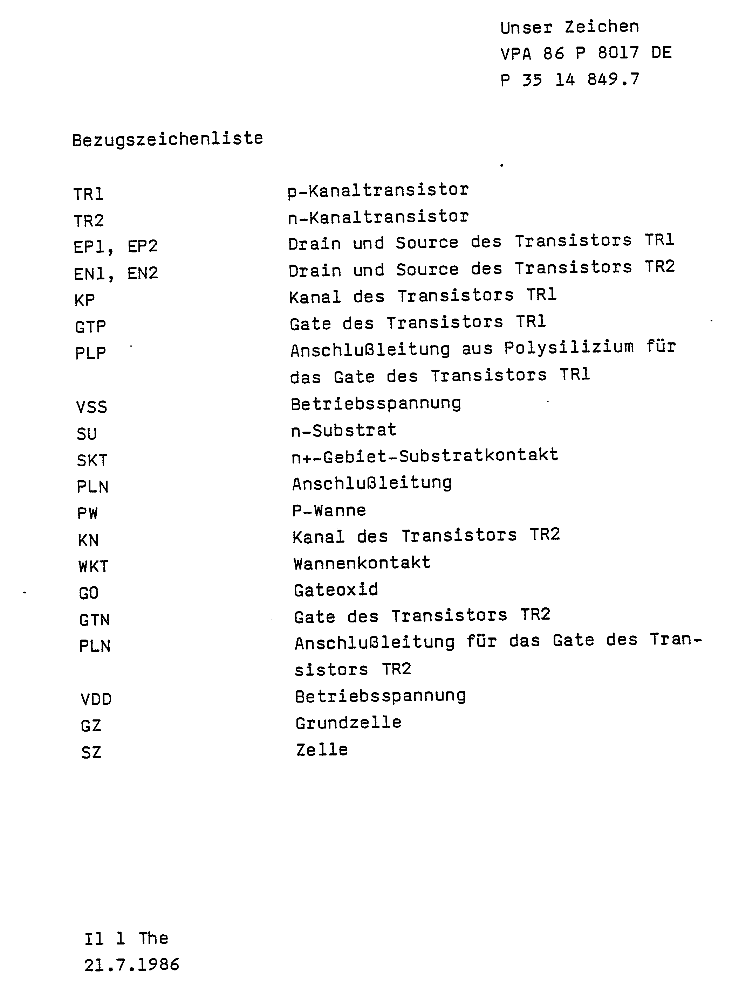

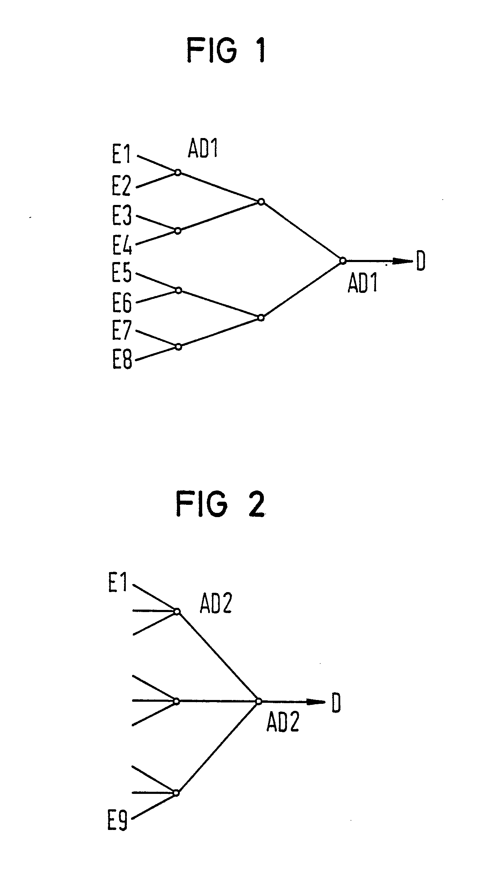

Die Prüfbits werden im einfachsten Fall durch Modulo-2-Addition zweier Binärstellen gefunden. Das logische Element, das diese Addition ausführen kann, heißt Exklusiv-Oder-Glied oder kurz EXOR-Glied. Sollen mehr als zwei Datenstellen binär addiert werden, so werden die Addierer in Form eines sog. Binärbaumes verschaltet. Ein Beispiel ist in Fig. 1 dargestellt. Es ist gezeigt, wie acht Eingangssignale E1 bis E8 zu einem Ausgangssignal D binär addiert werden. An den Kreuzungspunkten sind jeweils Addierer AD1 angeordnet. Für n Datenbits, also n Eingangssignale, werden n-1 Addierer benötigt, damit hat der Binärbaum eine Tiefe von m Stufen, wobei für m $2^m = n$ gilt. Die für die Ergebnisbildung benötigte Zeit bestimmt sich aus der Additionszeit eines Binäraddierers multipliziert mit der Tiefe des Binärbaumes. Zum Beispiel benötigt ein Prüfbitgenerator für acht Datenbits E1 bis E8 sieben Addierer AD1, die nach drei Additionszeiten das Ergebnis D gebildet haben.

Würden zur Prüfbitberechnung Addierer verwendet werden, die drei Eingangssignale oder drei Datenbits addieren können, so würde sich ein ternärer Baum entsprechend Fig. 2 ergeben. Hier werden für n Datenbits INT (n/2) Addierer benötigt und der Ternärbaum hat eine Tiefe von m Stufen, wobei für m $3^m = n$ gilt. Sollen entsprechend Fig. 2 acht Datenbits oder Eingangssignale verknüpft werden, dann werden vier dreiwertige Addierer AD2 benötigt, die nach zwei Additionszeiten das Ergebnis D gebildet haben. Werden nur acht der neun vorhandenen Eingänge nach Fig. 2 benutzt, so kann der verbleibende Eingang zum Umschalten von Even/Odd-Parity-Bildung benutzt werden.

Ternäre Bäume nach Fig. 2 haben somit Vorteile gegenüber binären Bäumen nach Fig. 1. Damit sich diese Vorteile auch praktisch anwenden lassen, müssen die dreiwertigen Addierer zwei Voraussetzungen erfüllen: Zum einen darf deren Addierzeit nicht sehr viel größer als die der zweiwertigen Addierer sein, zum anderen darf der Aufwand an Transistoren und damit der Flächenbedarf auf dem Chip nicht sehr viel größer als bei den binären Addierern sein.

Die der Erfindung zugrundeliegende Aufgabe besteht deshalb darin, einen Modulo-2-Addierer zur Verknüpfung von drei Eingangssignalen anzugeben, der im Vergleich zu einem Modulo-2-Addierer für zwei Eingangssignale nur eine geringfügig höhere Additionszeit benötigt und dessen Bedarf an Transistoren im Vergleich zum Binäraddierer nicht sehr viel größer ist, so daß die Verknüpfung von einer größeren Anzahl von Eingangssignalen mit Hilfe der dreiwertigen Addierer im Vergleich zur Verknüpfung mit zweiwertigen Addierern günstiger ist.

Diese Aufgabe wird bei einem Modulo-2-Addierer der eingangs angegebenen Art gemäß dem Kennzeichen des Patentanspruchs 1 gelöst.

Die Anzahl der zur Realisierung des dreiwertigen Addierers benötigten Schaltelemente, z.B. n-Kanal oder p-Kanal Transistoren, wird dann verringert, wenn pro Schaltungsteil zwei in den Schaltungszweigen von demselben und gleichgepolten Eingangssignal angesteuerte Schaltungselemente durch ein gemeinsames Schaltungselement ersetzt werden. Ein weiterer Vorteil des Modulo-2-Addierers besteht darin, daß auf einfache Weise ein Volladdierer geschaffen werden kann. Die Addierer eignen sich besonders für CMOS-Gate Arrays.

Weiterbildungen der Erfindung ergeben sich aus den Unteransprüchen.

Anhand von Ausführungsbeispielen, die in den Figuren dargestellt sind, wird die Erfindung weiter erläutert.

Es zeigen:

Fig. 1 einen bekannten Binärbaum für acht Eingangssignale und der Tiefe 3,

Fig. 2 einen bekannten Ternärbaum mit neun Eingangssignalen und der Tiefe 2,

Fig. 3 ein erstes Ausführungsbeispiel eines Modulo-2-Addierers für drei Eingangssignale,

Fig. 4 ein zweites Ausführungsbeispiel eines Modulo-2-Addierers für drei Eingangssignale,

Fig. 5 ein drittes Ausführungsbeispiel eines Modulo-2-Addierers für drei Eingangssignale,

Fig. 6 ein Volladdierer unter Verwendung des Modulo-2-Addierers der Fig. 4,

Fig. 7 ein Volladdierer unter Verwendung des Modulo-2-Addierers der Fig. 5.

Die Fig. 1 und 2 sind bereits oben erläutert worden. Fig. 1 zeigt die Verknüpfung von acht Eingangssignalen E1 bis E8 mit Hilfe von zweiwertigen Modulo-2-Addierern AD1, Fig. 2 die Verknüpfung von neun Eingangssignalen E1 bis E9 mit Hilfe von dreiwertigen Modulo-2-Addieren AD2. Der binäre Baum der Fig. 1 hat eine Tiefe von drei und benötigt sieben zweiwertige Addierer AD1. Bei Verwendung von dreiwertigen Modulo-2-Addierern AD2 sind zur Verknüpfung von acht Eingangssignalen vier Addierer AD2 notwendig und der ternäre Baum hat eine Tiefe von zwei.

Die Realisierung der dreiwertigen Modulo-2-Addierer ist in den folgenden Figuren gezeigt.

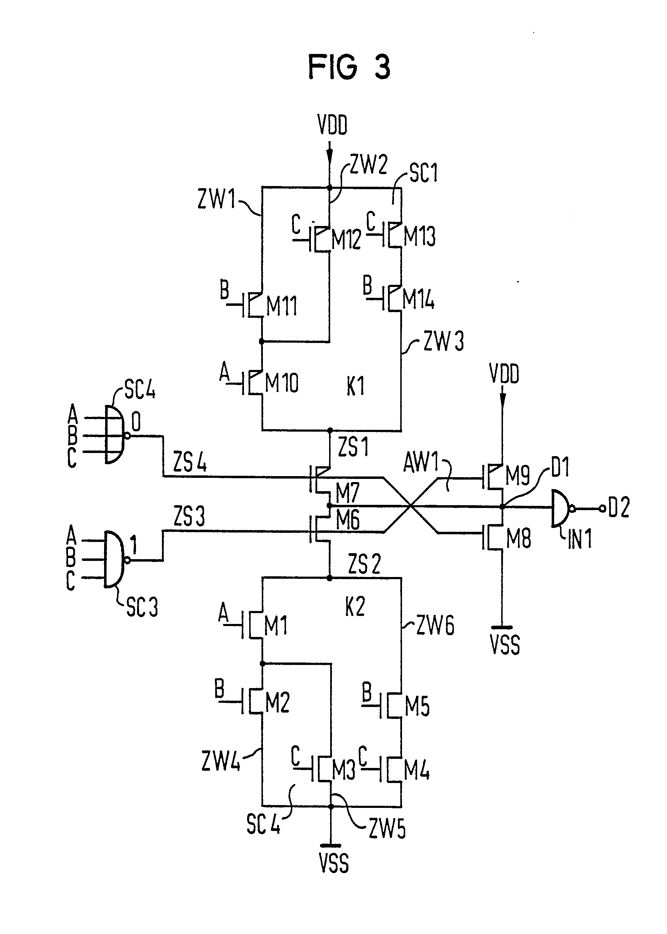

Nach Fig. 3 besteht der Modulo-2-Addierer für drei Eingangssignale A, B, C aus vier Schaltungsteilen SC1, SC2, SC3, SC4 und einer Auswerteschaltung AW1. Der Schaltungsteil SC1 ist aus drei Serienschaltungen aus jeweils zwei Schaltelementen aufgebaut, die zwischen einem ersten festen Potential VDD und einem Knoten K1 liegen. Die Serienschaltungen der Schaltelemente sind mit ZW1, ZW2 und ZW3 bezeichnet. Die Schaltelemente bestehen aus p-Kanaltransistoren und zwar M11 und M10 für ZW1, M10 und M12 für ZW2 und M13, M14 für ZW3. Bei den Zweigen ZW1 und ZW2 ist ein gemeinsamer Transistor M10 vorgesehen, da in beiden Zweigen dasselbe Eingangssignal A zu verarbeiten ist. Der gemeinsame Transistor M10 liegt benachbart dem Knoten K1. Mit Hilfe des ersten Schaltungsteils SC1 wird ein dem ersten Binärwert "1" zugeordnetes Zwischensignal ZS1 an den Knoten K1 angelegt, wenn von den Eingangssignalen A, B und C jeweils zwei den anderen Binärwert "0" annehmen.

Entsprechend dem Schaltungsteil SC1 ist der Schaltungsteil SC2 aufgebaut. Er liegt zwischen einem zweiten festen Poten tial VSS und einem Knoten K2 und weist drei Serienschaltungen ZW4, ZW5 und ZW6 auf. Die Serienschaltung ZW4 besteht aus Schaltelementen M2 und M1, ZW5 aus Schaltelementen M3 und M1 und ZW6 aus Schaltelementen M4 und M5. Die Schaltelemente M1 bis M5 sind n-Kanaltransitoren. Die Serienschaltungen ZW4 und ZW5 weisen den gemeinsamen Transistor M1 auf, dem das Eingangssignal A zugeführt wird. Dies ist deshalb möglich, weil in beiden Serienschaltungen ZW4 und ZW5 das Eingangssignal A verarbeitet werden muß. Mit Hilfe des Schaltungsteils SC2 wird ein dem anderen Binärwert "0" entsprechendes Zwischensignal ZS2 an den Knoten K2 angelegt, wenn mindestens zwei der Eingangssignale A, B, C den anderen Binärwert "1" einnehmen.

Der dritte Schaltungsteil SC3 besteht aus einem NAND-Glied, dem die Eingangssignale A, B und C zugeführt werden. Am Ausgang des dritten Schaltungsteils SC3 wird ein dem anderen Binärwert "0" entsprechendes Zwischensignal ZS3 abgegeben, wenn alle Eingangssignale A, B, C den einen Binärwert "1" annehmen.

Der vierte Schaltungsteil SC4 ist mit Hilfe einer NOR-Schaltung realisiert, der die drei Eingangssignale A, B, C zugeführt werden, und die am Ausgang ein dem einen Binärwert "1" entsprechendes Zwischensignal ZS4 erzeugt, wenn alle Eingangssignale A, B, C den anderen Binärwert "0" einnehmen.

Mit Hilfe der Auswerteschaltung AW1 wird nun das Zwischensignal ZS zum Ausgang D1 durchgeschaltet, das das Verknüpfungsergebnis der drei Eingangssignale A, B, C darstellt. Die Auswerteschaltung AW1 besteht aus Schaltelementen M7, M8, die in Serie zwischen den Knoten K1 und K2 angeordnet sind und aus einer Serienschaltung aus den Schaltelementen M8, M9, die zwischen dem ersten festen Potential VDD und dem zweiten festen Potential VSS liegt. Die Schaltelemente M7 und M9 sind p-Kanaltransistoren, die Schaltelemente M6 und M8 n-Kanaltransistoren.

Das Zwischensignal ZS2 wird über den Transistor M6 an den Ausgang D1 angelegt, wenn die NAND-Funktion des Schaltungsteils SC3 nicht erfüllt ist. Entsprechend wird das Zwischenergebnis ZS1 über den Transistor M7 an den Ausgang D1 angelegt, wenn die NOR-Funktion des Schaltungsteils SC4 nicht erfüllt ist. Ist die NAND-Funktion des Schaltungsteils SC3 erfüllt, dann ist der Transistor M6 gesperrt, dagegen der Transistor M9 durchlässig geschaltet. Damit wird das Zwischensignal ZS3 in invertierter Form an den Ausgang D1 angelegt. Ist dagegen die NOR-Funktion der drei Eingangssignale erfüllt, dann ist der Transistor M7 gesperrt und das Zwischensignal ZS4 steuert den Transistor M8 leitend, so daß das Zwischensignal ZS4 in invertierter Form am Ausgang D1 liegt.

Mit Hilfe der Auswerteschaltung AW1 wird somit gewährleistet, daß das Zwischensignal ZS1 zum Ausgang D1 gelangt, wenn zwei Eingangssignale binär "0" sind, daß das Zwischensignal ZS2 zum Ausgang D1 gelangt, wenn zwei Eingangssignale binär "1" sind und daß die Zwischensignale ZS3 bzw. ZS4 in invertierter Form zum Ausgang D1 gelangen, wenn alle Eingangssignale binär "1" bzw. binär "0" sind.

Am Ausgang D1 kann ein Inverterglied IN1 angeordnet werden, um eine Entkopplung der folgenden Schaltstufen von dem Modulo-2-Addierer nach Fig. 3 zu erreichen.

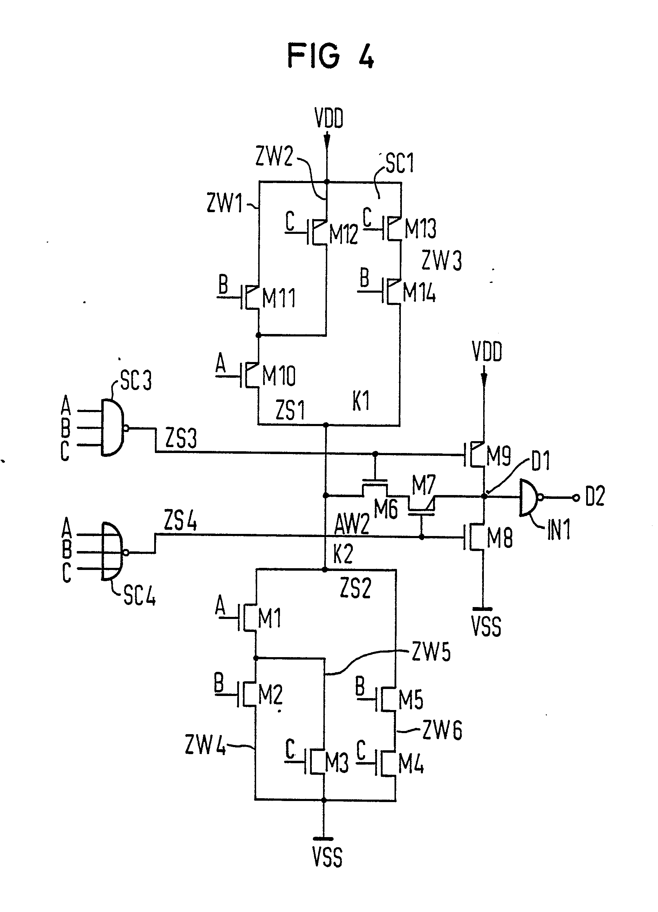

Der Modulo-2-Addierer nach Fig. 4 unterscheidet sich von dem der Fig. 3 nur dadurch, daß die Auswerteschaltung geändert worden ist. Die Auswerteschaltung AW2 besteht jetzt aus einer Serienschaltung der Schaltelemente M6 und M7, die zwischen den miteinander verbundenen Knoten K1, K2 der Schaltteile SC1 und SC2 und dem Ausgang D1 liegt. Weiterhin enthält die Auswerteschaltung AW2 ebenso wie die Auswerteschaltung AW1 nach Fig. 3 die Serienschaltung aus den Schaltelementen M9 und M8, die zwischen den festen Potentialen VDD und VSS liegen und bei der der Verbindungspunkt der Schaltelemente M8 und M9 den Ausgang D1 bildet.

Die Auswerteschaltung AW2 schaltet ZS1 und ZS2 zum Ausgang D1 durch, wenn die NAND-Funktion und NOR-Funktion nicht erfüllt ist. In diesem Falle sind die Schaltelemente M6 und M7 leitend gesteuert. Ist dagegen die NAND-Funktion oder die NOR-Funktion erfüllt, dann wird einer der Schaltelemente M6 und M7 gesperrt und nur noch entsprechend Fig. 3 das Zwischensignal ZS3 oder das Zwischensignal ZS4 in invertierter Form zum Ausgang D1 durchgeschaltet.

Die Schaltung nach Fig. 4 ist im Vergleich zur Schaltung nach Fig. 3 schneller, da die Transistoren M6 und M7 die Schaltungsteile SC1 und SC2 nicht mehr kapazitiv belasten.

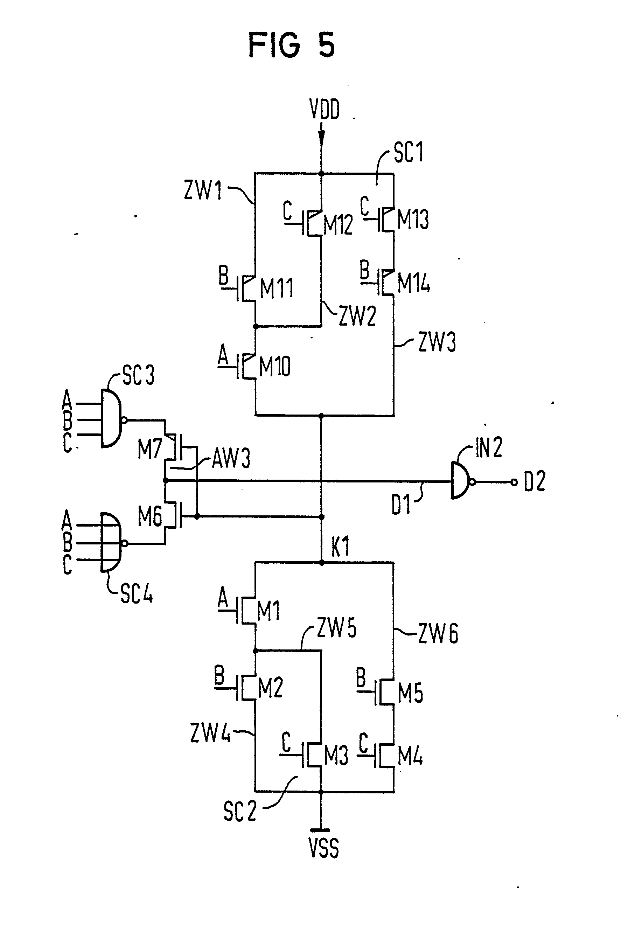

Der Modulo-2-Addierer nach Fig. 5 bringt noch eine weitere Vereinfachung der Auswerteschgaltung AW. Diese ist mit AW3 bezeichnet. Sie besteht jetzt nur noch aus den Schaltelementen M6 und M7, das Schaltelement M6 als n-Kanaltransistor, das Schaltelement M7 als p-Kanaltransistor. Die Steuereingänge der Transistoren M6 und M7 sind miteinander verbunden und führen zum Verbindungspunkt der Knoten K1 und K2 der Schaltungsteile SC1 und SC2. In Abhängigkeit des Potentials, das von den Zwischensignalen ZS1 und ZS2 der Schaltungsteile SC1 und SC2 abhängt, ist entweder der Transistor M6 leitend gesteuert oder der Transistor M7. Dementsprechend wird entweder das Potential am Ausgang des NOR-Gliedes SC4 oder des NAND-Gliedes SC3 an den Ausgang D1 gelegt. Wenn mehr als ein Eingangssignal binär 1 ist, dann ist der Knoten K1 binär 0, wenn mehr als eine 0 anliegt, dann ist der Knoten binär 1. Wenn also mehr als eine binäre 1 anliegt, dann ist der Transistor M7 durchgeschaltet, der Transistor M6 nicht leitend. Damit wird der Ausgang des NAND-Gliedes SC3 zum Ausgang D1 geschaltet. Dieser ist binär 0, wenn drei Eingangssignale binär 1 sind, dagegen binär 1, wenn weniger als drei Eingangssignale binär 1 sind.

Liegt dagegen mehr als eine binäre 0 am Eingang, dann ist der Knoten K1 binär 1, und somit der Transistor M6 leitend und der Transistor M7 gesperrt. Damit gelangt das Ausgangspotential ZS4 der NOR-Gliedes SC4 zum Ausgang D1. Sind dann drei Eingangssignale binär 0, dann ist das Ausgangssignal ZS4 binär 1, sonst binär 0. Über den Transistor M6 werden diese Binärwerte zum Ausgang D1 durchgeschaltet. Am Ausgang D1 ist wiederum ein Inverterglied IN2 angeordnet, zur Entkopplung. Der Schaltkreis nach Fig. 5 kann als nicht invertierender Binäraddierer mit drei Eingängen angesehen werden. Aufgrund der neu gestalteten AW3 wird der Ausgang noch weniger kapazitiv belastet, was zum Ergebnis hat, daß der Schaltkreis nach Fig. 5 schneller arbeitet als die Modulo-2-Addierer nach Fig. 3 und Fig. 4. Zum Beispiel braucht der Addierer nach Fig. 5 zur Verknüpfung von drei Eingangssignalen 2.3 ns, der Modulo-2-Addierer nach Fig. 4 2.77 ns, der Addierer nach Fig. 3 2,95 ns.

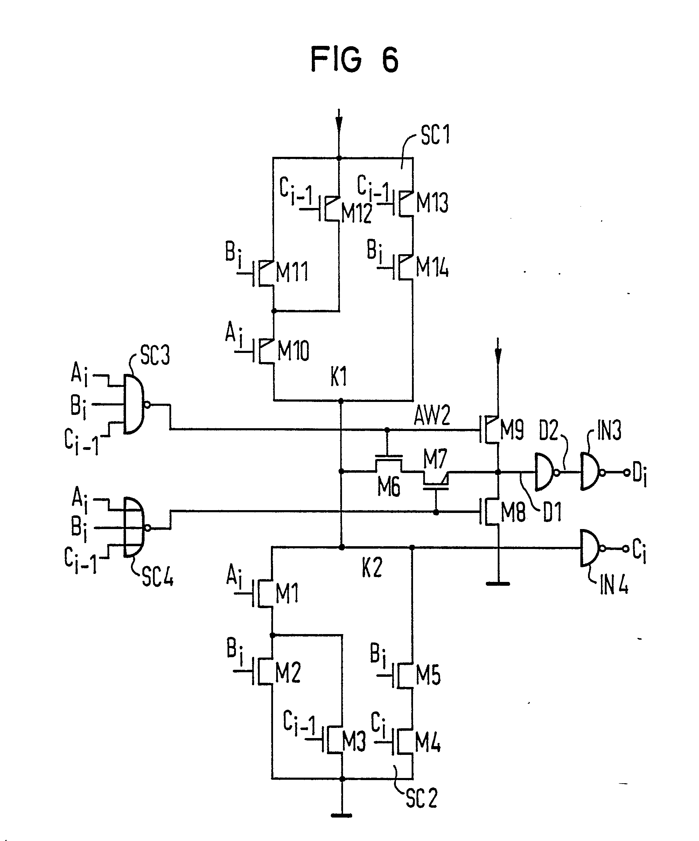

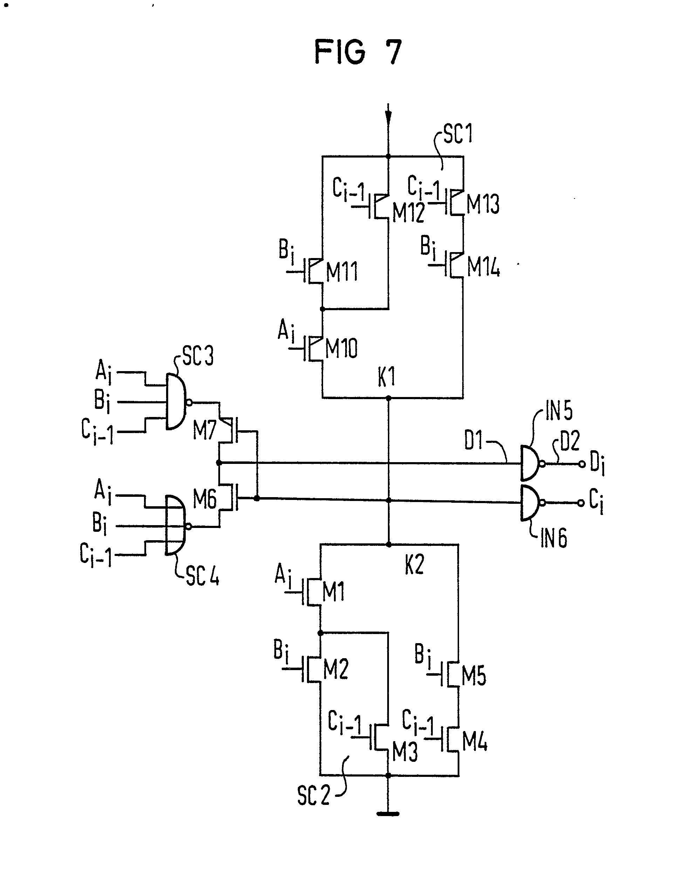

Die Fig. 6 und 7 zeigen Volladdierer, wobei der Volladdierer nach Fig. 6 von dem Modulo-2-Addierer nach Fig. 4, der Volladdierer nach Fig. 7 von dem Modulo-2-Addierern nach Fig. 5 ausgeht.

Die Funktion eines binären Volladdierers wird beschrieben durch:

$$D(i) = A(i) \oplus B(i) \oplus C(i-1)$$
$$C(i) = A(i) \, B(i) + A(i) \, C(i-1) + B(i) \, C(i-1)$$

$D(i)$ ist die binäre Summe der drei Eingangssignale $A(i)$ und $B(i)$ und des Übertrages $C(i-1)$, $C(i)$ ist der Übertrag an den nächsten Addierer. $D(i)$ ist damit der Ausgangswert einer der oben beschriebenen Binäraddierer mit drei Eingängen, $C(i)$ wird in den Schaltungen als Zwischenwert gebildet.

Dabei entspricht der Volladdierer nach Fig. 6 dem Modulo-2-Addierer nach Fig 4. Zusätzlich wird am Ausgang D2 ein weiteres Inverterglied IN3 angeschlossen, um den richtigen Logikpegel am Ausgang $D(i)$ zu erhalten. Den Übertrag für die nächste Stufe kann am Knoten K2, der mit dem Knoten K1 verbunden ist, abgegriffen werden und wegen des richtigen Logikpegels über ein Inverterglied IN4 zum Ausgang $C(i)$ geführt werden.

Der Volladdierer nach Fig. 7 geht von dem Modulo-2-Addierer der Fig. 5 aus. Die binäre Summe kann direkt am Ausgang D2 abgegriffen werden, der Übertrag für die nächste Addierstufe wird wiederum am Verbindungspunkt der Knoten K1 und K2 abgegriffen und über ein Inverterglied IN6 zum Ausgang Ci geführt.

Eine Simulation des Volladdierers nach Fig. 6 hat gezeigt, daß zur Gewinnung der binären Summe 3,27 ns, zur Bildung des Übertrages 1,62 ns erforderlich sind, während für den Volladdierer nach Fig. 7 zur Bildung der Binärsumme 2,30 ns, zur Bildung des Übertrages 1,62 ns notwendig sind.

## Ansprüche

1. Modulo-2-Addierer zur Verknüpfung von drei Eingangssignalen (A,B,C) **gekennzeichnet** durch folgende Merkmale:
-es ist ein erster Schaltungsteil (SC1) aus drei Schaltungszweigen (ZW1, ZW2, ZW3) mit jeweils zwei Schaltelementen (M10,M11; M10,M12; M13,M14) vorgesehen, die zwischen einem ersten festen Potential (VDD) und einem ersten Knoten (K1) liegen und die ein dem einen Binärwert ("1") entsprechendes Zwischensignal (ZS1) an den ersten Knoten legen, wenn jeweils zwei Eingangssignale den anderen Binärwert ("0") annehmen,

-es ist ein zweiter Schaltungsteil (SC2) aus drei Schaltungszweigen (ZW4, ZW5, ZW6) mit jeweils zwei in Serie geschalteten Schaltelementen (M1, M12; M1, M3; M4, M5) vorgesehen, die zwischen einem zweiten festen Potential (VSS) und einem zweiten Knoten (K2) liegen und die ein dem anderen Binärwert entsprechendes Zwischensignal (ZS2) an den zweiten Knoten liegen, wenn jeweils zwei Eingangssignale den einen Binärwert annehmen,

-es ist ein dritter Schaltungsteil (SC3) mit drei Eingängen für die drei Eingangssignale vorgesehen, der ein drittes dem anderen Binärwert entsprechendes Zwischensignal (ZS3) abgibt, wenn alle Eingangssignale (A,B,C) den einen Binärwert annehmen,

-es ist ein vierter Schaltungsteil (SC4) mit drei Eingängen für die drei Eingangssignale vorgesehen, der ein dem einen Binärwert entsprechendes viertes Zwischensignal (ZS4) erzeugt, wenn alle Eingangssignale den zweiten Binärwert annehmen,

-es ist eine Auswerteschaltung (AW) vorgesehen, die das erste oder zweite Zwischensignal (ZS1, ZS2) als Verknüpfungsergebnis zum Ausgang durchschaltet, wenn das dritte Zwischensignal (ZS3) den einen Binärwert und das vierte Zwischensignal (ZS4) den anderen Binärwert annimmt, sonst das dritte oder vierte Zwischensignal in invertierter Form.

2. Modulo-2-Addierer nach Anspruch 1, dadurch **gekennzeichnet,** daß die Schaltelemente der Schaltungszweige (ZW) des ersten und zweiten Schaltungsteils (SC1, SC2), denen dasselbe Eingangssignal (A) zugeführt wird, durch ein gemeinsames Schaltelement (M10,M1) ersetzt sind.

3. Modulo-2-Addierer nach Anspruch 1 oder 2, dadurch **gekennzeichnet,**daß die Schaltelemente des ersten Schaltungsteils (SC1) p-Kanaltransistoren sind.

4. Modulo-2-Addierer nach einem der vorhergehenden Ansprüche, dadurch **gekennzeichnet,** daß die Schaltelemente des zweiten Schaltungsteils (SC2) n-Kanaltransistoren sind.

5. Modulo-2-Addierer nach einem der vorhergehenden Ansprüche, dadurch **gekennzeichnet,** daß der dritte Schaltungsteil (SC3) ein NAND-Glied ist.

6. Modulo-2-Addierer nach einem der vorhergehenden Ansprüche, dadurch **gekennzeichnet,** daß der vierte Schaltungsteil (SC4) ein NOR-Glied ist.

7. Modulo-2-Addierer nach einem der vorhergehenden Ansprüche **gekennzeichnet** durch die Auswerteschaltung (AW2) aus

-einer zwischen den miteinander verbundenen ersten und zweiten Knoten (K1, K2) und dem Ausgang (D1) liegenden ersten Serienschaltung aus einem von dem dritten Schaltungsteil (SC3) und einem von dem vierten Schaltungsteil (SC4) gesteuerten Schaltelement (M6, M7),

-aus einer zwischen dem ersten festen Potential (VDD) und dem zweiten festen Potential (VSS) angeordneten zweiten Serienschaltung aus zwei Schaltelementen (M9,M8), von denen das erste (M9) an das erste feste Potential (VDD) angeschlossene Schaltelement von dem dritten Schaltungsteil (SC3), das zweite (M8) an das zweite feste Potential (VSS) angeschlossene Schaltelement (M8) von dem vierten Schaltungsteil (SC4) gesteuert wird und deren Verbindungspunkt (D1) den Ausgang bildet.

8. Modulo-2-Addierer nach einem der Ansprüche 1 bis 6, **gekennzeichnet** durch die Auswerteschaltung (AW1) aus

-einer zwischen dem ersten und dem zweiten Knoten (K1,K2) liegenden dritten Serienschaltung aus zwei Schaltelementen (m6,M7), von denen das erste mit dem ersten Knoten (k1) verbundene Schaltelement (M7) von dem vierten Schaltungsteil (SC4), das zweite mit dem zweiten (K2) verbundene Schaltelement (M6) von dem dritten Schaltungsteil (SC3) gesteuert wird und deren Verbindungspunkt an den Ausgang (D1) angeschlossen ist,

-aus einer zwischen dem ersten und dem zweiten festen Potential (VDD, VSS) angeordneten vierten Serienschaltung aus zwei Schaltelementen (M9,M8), von denen das erste an das erste feste Potential (VDD) angeschlossene Schaltelement von dem dritten Schaltungsteil (SC3), das zweite an das zweite feste Potential (VSS) angeschlossene Schaltelement (M8) von dem vierten Schaltungsteil (SC4) gesteuert wird und deren Verbindungspunkt an den Ausgang (D1) angeschlossen ist.

9. Modulo-2-Addierer nach einem der Ansprüche 1 bis 6, **gekennzeichnet** durch eine Auswerteschaltung (AW3) aus einer zwischen dem dritten und vierten Schaltungsteil(SC3, SC4) angeordneten fünften Serienschaltung aus zwei Schaltelementen (M6, M7), deren Verbindungspunkt den Ausgang (D1) bildet, deren Steuereingang an den miteinander verbundenen ersten und zweiten Knoten (K1, K2) an geschlossen ist und von denen das erste Schaltelement (M7) mit dem Ausgang des dritten Schaltungsteils (SC3), das zweite Schaltelement (M6) mit dem Ausgang des vierten Schaltungsteils (SC4) verbunden ist.

10. Modulo-2-Addierer nach Anspruch 7 oder 8, dadurch **gekennzeichnet,**daß die von dem dritten Schaltungsteil (SC3) angesteuerten Schaltelemente der ersten und dritten Serienschaltung n-Kanaltransistoren, die von dem vierten Schaltungsteil (SC4) angesteuerten Schaltelemente der ersten und dritten Serienschaltung p-Kanaltransistoren sind, während das von dem dritten Schaltungsteil angesteuerte Schaltelement der zweiten und vierten Serienschaltung ein p-Kanaltransistor, das von dem vierten Schaltungsteil angesteuerte Schaltelement der zweiten und vierten Serienschaltung ein n-Kanaltransistor ist.

11. Modulo-2-Addierer nach Anspruch 9, dadurch **gekennzeichnet,** daß das mit dem dritten Schaltungsteil (SC3) verbundene Schaltelement der fünften Serienschaltung ein p-Kanaltransistor (M7), das mit dem vierten Schaltungsteil (SC4) verbundene Schaltelement der fünften Serienschaltung ein n-Kanaltransistor ist.

12. Modulo-2-Addierer nach einem der vorhergehenden Ansprüche, dadurch **gekennzeichnet,** daß an dem Ausgang (D1) ein Inverterglied (IN1, IN2) angeschlossen ist.

13. Binärer Volladdierer unter Verwendung des Modulo-2-Addierers nach Anspruch 7, dadurch **gekennzeichnet,** daß am Ausgang die Summe der Eingangssignale bestehend aus zwei Summanden und dem Übertrag der vorhergehenden Stufe abgegeben wird, und daß der Verbindungspunkt des ersten und zweiten Knotens (K1, K2) an ein Inverterglied (IN 4) angeschlossen ist, an dessen Ausgang der Übertrag für die nächste Addierstufe abgegeben wird.

14. Binärer Volladdierer unter Verwendung des Modulo-2-Addierers nach Anspruch 9, dadurch **gekennzeichnet,** daß an den Verbindungspunkt der fünften Serienschaltung (M7, M6) ein Inverterglied (IN5) angeschlossen ist, an dessen Ausgang die Summe der aus zwei Summanden und dem Übertrag von der vorhergehenden Stufe bestehenden Eingangssignale abgegeben wird, und daß an den Verbindungspunkt des ersten und zweiten Knotens (K1,K2) ein weiteres Inverterglied (IN6) angeschlossen ist, an dessen Ausgang der Übertrag für die nächste Addierstufe abgegeben wird.

Unser Zeichen
VPA 86 P 8017 DE
P 35 14 849.7

Bezugszeichenliste

| | |
|---|---|
| TR1 | p-Kanaltransistor |
| TR2 | n-Kanaltransistor |
| EP1, EP2 | Drain und Source des Transistors TR1 |
| EN1, EN2 | Drain und Source des Transistors TR2 |
| KP | Kanal des Transistors TR1 |
| GTP | Gate des Transistors TR1 |
| PLP | Anschlußleitung aus Polysilizium für das Gate des Transistors TR1 |
| VSS | Betriebsspannung |
| SU | n-Substrat |
| SKT | n+-Gebiet-Substratkontakt |
| PLN | Anschlußleitung |
| PW | P-Wanne |
| KN | Kanal des Transistors TR2 |
| WKT | Wannenkontakt |
| GO | Gateoxid |
| GTN | Gate des Transistors TR2 |
| PLN | Anschlußleitung für das Gate des Transistors TR2 |
| VDD | Betriebsspannung |
| GZ | Grundzelle |
| SZ | Zelle |

Il 1 The
21.7.1986

# FIG 1

# FIG 2

FIG 3

# FIG 4

# FIG 5

FIG 6

# FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-2 516 674 (LABORATOIRE CENTRAL DE TELECOMMUNICATIONS S.A.) <br> * Seite 4, Zeilen 12-36; Figur 4 * <br><br> ----- | 1-6,9, 11,14 | H 03 K 19/21 <br> G 06 F 7/50 |

**RECHERCHIERTE SACHGEBIETE (Int. Cl.4)**

H 03 K
G 06 F
H 03 M

Der vorliegende Recherchenbericht wurde für alle Patentansprüche erstellt.

| Recherchenort | Abschlußdatum der Recherche | Prüfer |
|---|---|---|
| DEN HAAG | 09-06-1987 | BEINDORFF W.H. |